# EUROPÄISCHE PATENTANMELDUNG

(11) **EP 3 462 182 A1**
(43) Veröffentlichungstag der Anmeldung: **03.04.2019**
(21) Anmeldenummer: 17193682.6
(22) Anmeldetag: 28.09.2017
(51) Int. Cl.: G01R 13/00, G01R 13/12, G01R 31/34, G01R 31/02, G01R 31/06, H01B 3/40, H02K 3/30, H02K 3/40, H02K 15/12, G01R 31/12

(54) **PASSIVE KOMPONENTE ZUM NACHWEIS ELEKTRISCHER ÜBERBEANSPRUCHUNG IN ELEKTRISCH ROTIERENDEN MASCHINEN**

(71) Anmelder: Siemens Aktiengesellschaft, 80333 München (DE)
(72) Erfinder: Heller, Janis, 97616 Bad Neustadt (DE); Katzenberger, Tobias, 97631 Bad Königshofen STT Untereßfeld (DE); Maleika, Marek, 90766 Fürth (DE); Plochmann, Bastian, 91413 Neustadt an der Aisch (DE)

(57) **Zusammenfassung**

Die Erfindung betrifft eine passive Komponente, um die Qualität und den Zustand des Isolationssystems eines elektrischen Motors festzustellen. Dies dient insbesondere dazu, eine Prognose vor dem Ausfall des Motors, beispielsweise eine Durchschlag zwischen zwei Phasen, zu erstellen. Durch die vorliegende Erfindung wird erstmals eine passive Komponente wie ein Teststreifen zur Verfügung gestellt, durch die während des Betriebs einer elektrischen Maschine die Belastungen, die durch Teilentladungen und/oder Spannungsspitzen auf das Isolationssystem wie beispielsweise die Wicklung wirken, - beispielsweise optisch - erfassbar sind.

## Beschreibung

Die Erfindung betrifft eine passive Komponente, um die Qualität und den Zustand des Isolationssystems eines elektrischen Motors festzustellen. Dies dient insbesondere dazu, eine Prognose vor dem Ausfall des Motors, beispielsweise eine Durchschlag zwischen zwei Phasen, zu erstellen.

Drei-Phasen-Elektromotoren für Netzspannungen von - beispielsweise - bis zu 690V werden typischerweise mittels eines Umrichters betrieben oder befinden sich in einem Umrichter-gespeisten Umfeld. Dies ist sinnvoll, um gezielte Spannungswerte in Form von Rechteckspannungen zu erzeugen, damit die Drehzahl beliebig steuerbar ist und ein möglichst effizienter Betrieb des Motors möglich ist.

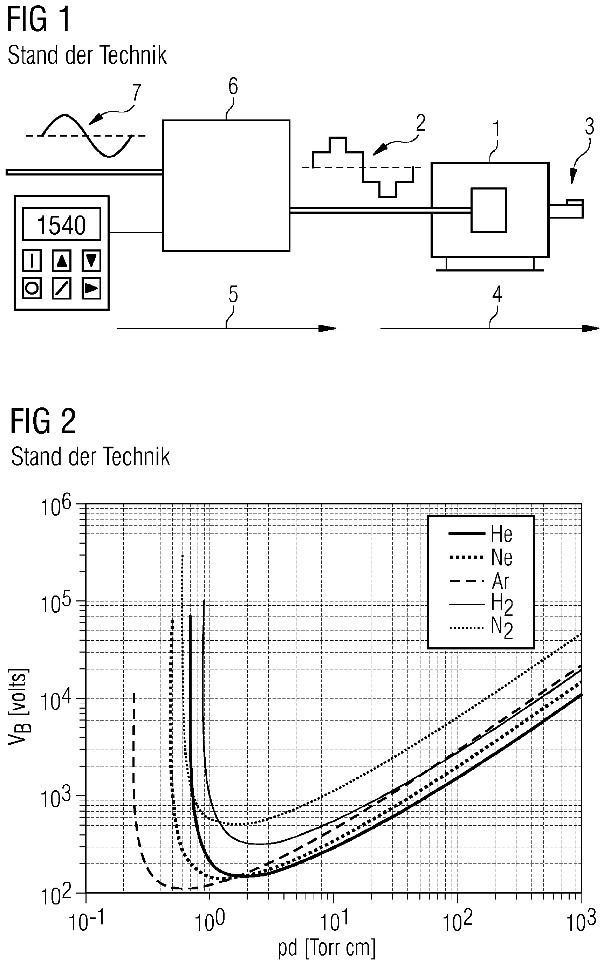

Das Prinzip eines Umrichters ist, nach dem Stand der Technik, in Figur 1 gezeigt. Figur 1 zeigt die Wandlung 5 einer Sinusschwingung 7 über eine Frequenzsteuerung 6 in eine Rechteckspannung 2, die im Wechselstrommotor 1 in mechanische Energie 3 durch die Energiewandlung 4 gewandelt wird.

Zu erkennen ist, wie Rechteckspannungen 2 im Wechselstrommotor 1 in mechanisch nutzbare Energie 3 gewandelt werden.

Da es sich bei Rechteckspannungen 2 um eine Vielzahl überlagerter Sinusschwingungen 7 mit sehr hohen Frequenzen handelt, wie in einschlägigen Lehrbüchern über Fourier-Transformation näher erläutert ist, kommt es im Flankenbereich zu Pulsartigen Überspannungen, die als Wellen durch die Wicklungen des Isolationssystems laufen. Das Isolationssystem selbst umfasst nach dem Stand der Technik beispielsweise einen Metalldraht, insbesondere Kupferdraht, der lackisoliert ist, wobei der Lack beispielsweise auf Basis eines Polyesterimids, Amidimid-Polymers gebildet ist. Darüber befinden sich herkömmlich Flächenisolierstoffe, die beispielsweise Mehrschichtlaminate auf Polyester- und/oder Meta-Aramidbasis aufgebaut sind, und mit einem Imprägnier- und/oder Tränkharz, beispielsweise einem Polyesterharz, das vorzugsweise gefüllt ist, vergossen sind. Trotz dieser ausgefeilten Isolationssysteme kommt es immer wieder zu Erosionen, weil das Isolationssystem doch nicht für die auftretenden Überspannungen, welche ein Vielfaches der Betriebs-Spannungen betragen können, ausgelegt ist.

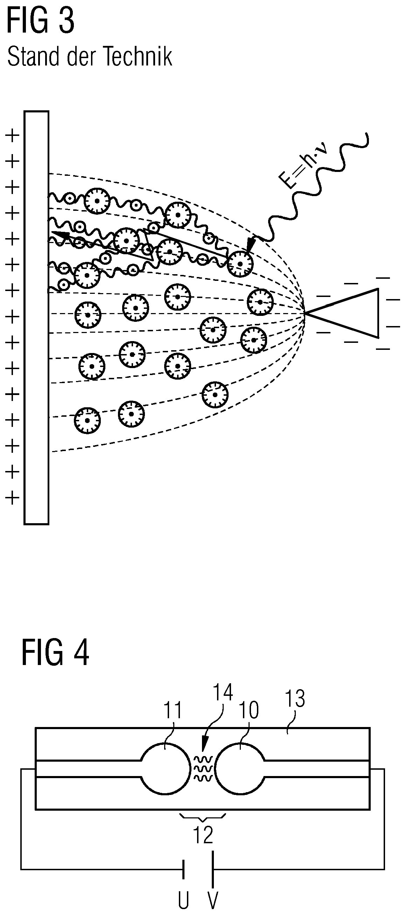

Aufgrund der Tatsache, dass sich in einem realen Isolieraufbau Poren und Spalten im Mikrometer- bis Millimeter-Maßstab befinden, deren Anzahl durch den realen Fertigungsvorgang des Isolationssystems, also Imprägnierung, Tränkung, Verguss zwar minimiert, aber nicht komplett verhindert werden können, kommt es bei Spannungsüberhöhungen notgedrungen zu Teilentladungen. Diese zünden aufgrund der meist niedrigeren Dielektrizitätskonstante in den Fehlstellen (Feldverdrängung) gemäß dem Paschen-Gesetz bei Normaldruck ab einer gewissen Feldstärke, wie in Figur 2 gezeigt ist, also Spannung pro Porendurchmesser durch einen Lawineneffekt der Ladungsträger, wie in Figur 3 zu sehen ist.

Figur 2 zeigt eine Graphik, die den Zusammenhang, der durch das Paschen-Gesetz formuliert wurde, darstellt.

Figur 3 zeigt das Schema von der Entstehung von Teilentladungen durch Lawineneffekt.

Organische Isolierstoffe, wie beispielsweise die oben genannten Imprägnierharze, die in den Isolationssystemen eingesetzt werden, werden durch die Energie der Teilentladungen sukzessive degradiert, so dass es zu einer Schädigung des Isolationssystems bevorzugt in vorhandenen Fehlstellen kommt und diese vergrößert bis es zu einem Ausfall kommt.

Die Qualität und der Zustand des Isolationssystems eines Motors sind von außen schwer quantitativ festzustellen, was letztendlich eine Prognose vor dem eigentlichen Totalausfall - beispielsweise in Form eines Durchschlags zwischen zwei Phasen oder zur Erde oder zweier Drähte - bei laufender Maschine nicht möglich macht. Nach einem Totalausfall kann zwar durch Ausbau der Wicklungen aus dem Ständerpaket und durch optische Betrachtung der Schädigungsverlauf und der Schädigungs-Mechanismus nachvollzogen werden, es kann aber meist keine Aussage über eine mögliche überhöhte Fremdspannung im Verbrauchernetz, wie beispielsweise Spannungsspitzen durch Umrichter-Betrieb oder zu hohe Betriebsspannung, gemacht werden.

Daher besteht der Bedarf, während des Betriebs Informationen über überhöhte Betriebsspannung und Spannungsspitzen zu bekommen, um ein besseres technisches Verständnis des beanspruchten Isolationssystems zu erlangen.

So ist es Aufgabe der vorliegenden Erfindung, eine passive Komponente zur Verfügung zu stellen, die ohne Eingriff an den im Betrieb befindlichen Motor anschließbar ist und eine Aussage darüber liefert, welche Belastungen das Isolationssystem bereits ausgesetzt ist und/oder bereits ausgesetzt war.

Diese Aufgabe wird durch den Gegenstand der vorliegenden Anmeldung, wie er in den Ansprüchen, der Beschreibung und den Figuren offenbart ist, gelöst.

Dementsprechend ist Gegenstand der vorliegenden Erfindung eine passive Komponente, ein Substrat und daran zumindest zwei Leiterbahnen umfassend, dergestalt, dass das Substrat eine elektrisch isolierende Brücke zwischen zumindest zwei Phasen einer elektrisch rotierenden Maschine bildet und die Leiterbahnen an jeweils eine Phase gekoppelt sind, damit an der elektrisch isolierenden Brücke die gleiche elektrische Spannung wie im Isolationssystem der Maschine anliegt, so dass die Spannungsbelastung der passiven Komponente der Spannungsbelastung des Isolationssystems entspricht.

Nach einer vorteilhaften Ausführungsform der Erfindung lässt sich der Zustand der Leiterbahnen über einen Farbstoff, der in den Leiterbahnen integriert ist, ablesen. Dabei lassen sich beispielsweise über die Ausbreitung und Ausprägung des Farbumschlages Rückschlüsse auf die Intensität und Wirkungsdauer von Überspannungen und somit Teilentladungen in den Wicklungen des Motors ziehen, weil sich der organische Farbstoff durch den lokalen Energieeintrag zersetzt können durch die Farbänderung des Verbundwerkstoffes und/oder der Leiterbahn die Dauer und die Intensität der Überspannung im laufenden Betrieb des Motors aufgezeichnet und ausgewertet werden. Totalausfälle werden damit vermieden.

Allgemeine Erkenntnis der Erfindung ist, dass sich im Anschlussbereich des Motors, beispielsweise dem Klemmbrett, dem Klemmkasten und/oder dem Verteiler mehrere, beispielsweise 3 Phasen befinden. Diese sind voneinander isoliert und somit kann von den einzelnen Phasen-Anschlüssen die Spannungsdifferenz abgegriffen werden, welche in dem Isolationssystem, beispielsweise in den Wicklungen, vorliegt. Deshalb ist es möglich durch Leiterbahnen in einer Struktur, welche im mittleren Bereich isolierend ist und abhängig vom Radius und Abstand je nach anliegender Spannung Teilentladungen zündet, durch geschickte Wahl von Signalen, beispielsweise einem Farbstoff, der durch Teilentladungen zerstört und damit farblos wird, festzustellen, wann Spannungsspitzen an den Phasen-anschlüssen und damit am Isolationssystem auftreten.

Die Leiterbahnen liegen dabei auf einem elektrisch isolierenden Substrat, dass eine elektrisch isolierende Brücke zwischen den Phasenanschlüssen bildet.

Das Substrat kann in Form eines Plättchens und/oder einer Folie vorliegen und ist beispielsweise aus üblichen Flächenisolierstoffen hergestellt, insbesondere wie Mehrschichtlaminate auf Polyester- und/oder Meta-Aramidbasis hergestellt sein. Diese können beispielsweise auch mit Glasfasern verstärkt sein.

Nach einer vorteilhaften Ausführungsform der Erfindung liegt die passive Komponente in Form eines einfachen Teststreifens vor, der zwischen zwei Phasen im Klemmkasten einer elektrischen Maschine auch während des Betriebs ohne Aufwand anbringbar, beispielsweise anklebbar und/oder anschraubbar ist, wobei die Geometrie der zumindest zwei Leiterbahnen, die jeweils an einen Phasenanschluss im Klemmkasten gekoppelt sind, so gewählt ist, dass ein Bereich der passiven Komponente zwischen den Leiterbahnen elektrisch isoliert ist und so kein Kurzschluss zwischen den Leiterbahnen entsteht.

Auf und/oder unter das Substrat werden zur Herstellung der passiven Komponente beispielsweise zwei Leiterbahnen aus einem Verbundwerkstoff, der bis mindestens zur Perkolationsschwelle mit elektrisch leitfähigem Füllstoff gefüllt ist, angeordnet. Beispielsweise hat der Verbundwerkstoff auf dem Substrat einen Quadratwiderstand bei einer Schichtdicke von ca 50pm bis 500µm unter 100kOhm. Bei zu großem Quadratwiderstand ergibt sich - abhängig von der Geometrie - das Problem, dass die Spannungsspitzen bereits in einer der Leiterbahnen oder in beiden abgebaut werden.

Für den Fall, dass als Signal oder Skala ein Farbumschlag eines in das Leiterbahn-Material integrierten Farbpigments gewählt wird, ist es günstig, wenn der elektrisch leitfähige Verbundwerkstoff, aus dem die Leiterbahnen hergestellt sind, selbst hell und/oder farblos ist. Dazu eignen sich insbesondere Imprägnier- oder Vergussharze, die selbst farblos sind und mit hellen leitfähigen oder teilleitfähigen Partikeln gefüllt sind.

Beispielsweise werden als Harze die für die Imprägnierung üblichen Epoxidharze entweder mit Säureanhydrid-haltigen Härtern, wie es im Moment noch Stand der Technik ist und/oder mit säureanhydridfreien Härtern, wie Ammonium-, Sulphonium-, Phosphonium- und/oder Iodoniumhärtern, sowie Härtern aus tertiären Aminen, Imidazol- und/oder Pyrazolverbindungen, eingesetzt. Diese sind weitläufig und beispielsweise auch aus der EP 3175462 bekannt.

Die Füllstoffpartikel sind bevorzugt plättchenförmige und/oder sphärische Partikel, beispielsweise auf Glimmerbasis und/oder Quarzmehlbasis. Diese sind - wiederum beispielsweise - mit einem hellen, dotierten Metalloxid beschichtet und damit leitfähig gemacht. Die Füllstoffpartikel können auch unbeschichtet vorliegen und/oder nur aus dotiertem Metalloxid gemacht sein.

So hergestellte Leiterbahnen sind farblos oder zumindest ganz hell, so dass sie durch Zugabe von Farbstoff auch in ganz geringen Mengen farbig gemacht werden können. Im Betrieb wird der Farbstoff durch Teilentladungen oder Spitzenspannungen zersetzt und die Farbe der Leiterbahn verschwindet wieder. Damit ist dann eine Aussage über die Belastung des Isolationssystems während des Betriebs möglich. Es können alle Arten von Farbstoffen hier eingesetzt werden, welche in dem Verbundwerkstoff und/oder in dem Material des Substrats zur Herstellung der Leiterbahnen integrierbar sind und durch Teilentladungen ihre optischen Eigenschaften ändern oder degradiert werden.

Beispielsweise eine folgende Zusammensetzung eignet sich als Mischung zur Herstellung einer Leiterbahn:
0,3 bis 7 Gew%, insbesondere 0,7 bis 5 Gew% und insbesondere 0,8 bis 2,5 Gew% an Farbstoff;
5 bis 50 Vol% an Füllstoff, insbesondere 20 bis 50 Vol% an Füllstoff, jedenfalls Füllstoff in einer Menge, in der er überperkolär, also oberhalb der Perkolationsschwelle, vorliegt;
Epoxidharz in einer Menge, dass ein Verdrucken mit oder ohne Lösungsmittel möglich ist, beispielsweise eine Menge von mindestens 15 Gew%, insbesondere mindestens 20 Gew% und bevorzugt mindestens 30 Gew%.

Als Beispiel sei die Herstellung einer Leiterbahn beschrieben:
- ca. 1 Gew% an Farbstoff,
- ca. 50 Gew% an Füllstoff aus dotiertem Zinnoxid und
- 49 Gew% Epoxidharz mit Härter
Werden zu einem Rakelfähigen Gemisch verarbeitet und dann mittels Rakel auf das Substrat aufgebracht.

Die Aufbringung der Leiterbahnen auf und/oder unter dem Substrat kann über Drucken, Siebdrucken, Dispenser-Drucken, Pinseln, Prägen, Sprühen und/oder Dispensen erfolgen.

Bei der passiven Komponente nach einem Ausführungsbeispiel der Erfindung liegt der Quadratwiderstand der jeweiligen Leiterbahn bei einer Schichtdicke im Bereich von 50 µm bis 500µm im Bereich von 10² bis 10⁷, insbesondere kann ein Quadratwiderstand im Bereich von 10³ bis 10⁵ Ohm bei einer Schichtdicke im Bereich von 70µm bis 200µm vorliegen.
Beispielsweise liegt eine durch Drucken aufgebrachte Leiterbahn mit einem Quadratwiderstand bei einer Schichtdicke von 100µm von ca. 10⁴ Ohm vor.

In Figur 4 ist eine entsprechend hergestellte passive Komponente in Form eines Teststreifens 13 dargestellt. Zu erkennen sind die beiden Leiterbahnen 10,11, die an jeweils eine Phase U, V angeschlossen sind. Zwischen den beiden Leiterbahnen 10,11 liegt der mittige Bereich 12, der freiliegendes Substrat zeigt und elektrisch isoliert ist. Abhängig vom Radius und dem Abstand der beiden Leiterbahn-Enden zünden hier je nach anliegender Spannung Teilentladungen 14, die den Farbstoff 15, der in den Leiterbahnen 10,11 integriert ist und diese farbig macht, zersetzen. Durch den Farbumschlag der Leiterbahnen kann bei dem hier gezeigten Ausführungsbeispiel das Vorliegen einer Spannungsspitze oder einer Teilentladung nachgewiesen werden.

Bei der hier gezeigten Ausführungsform der Erfindung liegen die beiden Leiterbahnen auf der gleichen Seite des Substrats, sie können jedoch auch auf gegenüberliegenden Seiten des Substrats liegen, so dass die Teilentladung durch das Substrat hindurch erfolgt, respektive zündet.

Nach einer vorteilhaften Ausführungsform der Erfindung ist die Geometrie der beiden Leiterbahnen, insbesondere deren Abstand und Radius so an das jeweils zu untersuchende Isolationssystem angepasst, dass bei Betriebsspannung des Motors gerade noch keine Teilentladungen einsetzen. Durch verschiedene Geometrien der Leiterbahnen können bei gleicher Spannung unterschiedliche Feldstärken erzeugt und somit eine feine Differenzierung des Schädigungsvorgangs durch optische Analyse erstellt werden.

Es ist nach einer Ausführungsform der Erfindung beispielsweise vorgesehen, dass der Meßstreifen zwischen zwei Phasen in das Klemmbrett des Motors integriert ist. Damit liegt am Meßstreifen die gleiche elektrische Spannung an wie im Isolationssystem und daher ist bei auftretenden Spannungsspitzen eine Zündung der Teilentladung möglich, die über Farbverlust detektierbar ist.

In einem Test wurde eine Versuchsspannung von 6kV über mehrere Stunden hinweg angelegt, wodurch der integrierte Farbstoff lokal degradiert wurde. Bei Verringerung der Dauer und der Intensität war der Radius des Farbumschlags kleiner, aber immer scharf zu erkennen. Die Ausbreitung und die Ausprägung des Farbumschlags läßt somit Rückschlüsse auf die Intensität und Wirkungsdauer von Überspannungen und somit Teilentladungen im Isolationssystem zu.

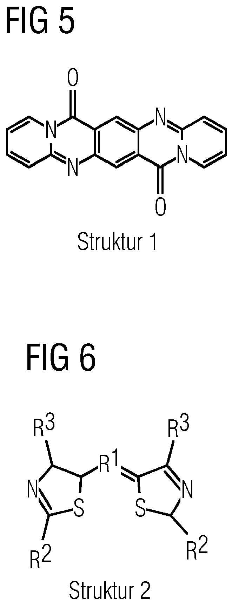

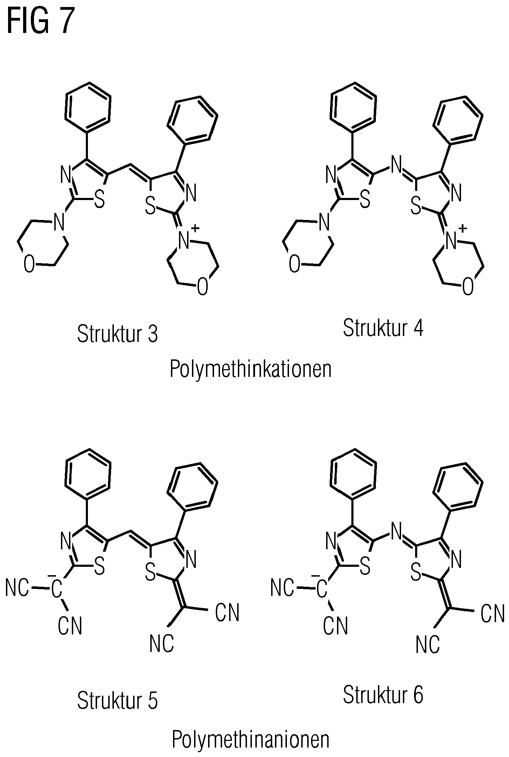

Als Farbstoff werden folgende Verbindungen beispielsweise eingesetzt, wie z.B. in den Strukturen 1 bis 6, die in den Figuren 5 bis 7 zu sehen sind, gezeigt.

Der Substituent R¹ steht dabei für CH, konjugierten Alkylspacer, also einen Alkylsubstituenten mit Doppelbindung (en), sowie Stickstoff, Schwefel, Phosphor, Sauerstoff und weitere Substituenten, die eine Konjugation zwischen dem Donor und Akzeptor der Polymethine ermöglichen und damit sowohl eine kräftige Färbung als auch eine Stabilität des Moleküls bewirken, steht.

Die Reste R² und R³ können gleich oder ungleich sein und stehen für beliebige Alkyl- und Aryl-Substituenten auch mit Chlorid- und/oder Fluorid-Substituenten, sowie weitere Gruppen, die beispielsweise die Bildung von Polymethin-Kationen und/oder Polymethin-Anionen begünstigen.

Möglicherweise werden auch Polymethin-Kationen oder Polymethin-Anionen in Form ihrer Salze eingesetzt, wobei der oder die jeweilige(n) Gegenspieler einzeln oder in beliebigen Kombinationen ausgewählt sein können aus der Gruppe folgender Ionen:
Kationen:
   - Einwertige anorganische oder organische Kationen, insbesondere Metallkationen
   - Zweiwertige Kationen, insbesondere Erdalkalikationen
   - Organische stickstoffhaltige Kationen
   - Trimethylhydrogenammmonium
   - Triethylhydrogenammonium
Anionen:
   - Halogenid-Anionen, wie Cl⁻; Br⁻;
   - Tetrafluoroboratanion BF₄⁻;
   - Hexfluorophosphatanion PF₆⁻;
   - Organische Anionen einfacher Wertigkeit

Durch die vorliegende Erfindung wird erstmals eine passive Komponente wie ein Teststreifen zur Verfügung gestellt, durch die während des Betriebs einer elektrischen Maschine die Belastungen, die durch Teilentladungen und/oder Spannungsspitzen auf das Isolationssystem wie beispielsweise die Wicklung wirken, - beispielsweise optisch - erfassbar sind.

## Patentansprüche

1. Passive Komponente, ein Substrat und daran zumindest zwei Leiterbahnen umfassend, dergestalt, dass das Substrat eine elektrisch isolierende Brücke zwischen zumindest zwei Phasen einer elektrisch rotierenden Maschine bildet und die Leiterbahnen an jeweils eine Phase gekoppelt sind, damit an der elektrisch isolierenden Brücke die gleiche elektrische Spannung wie im Isolationssystem der Maschine anliegt, so dass die Spannungsbelastung der passiven Komponente der Spannungsbelastung des Isolationssystems entspricht.

2. Passive Komponente nach Anspruch 1, die in Form eines Teststreifens vorliegt.

3. Passive Komponente nach Anspruch 1 oder 2, die im Klemmkasten eines Motors vorgesehen ist.

4. Passive Komponente nach einem der vorhergehenden Ansprüche, wobei die Leiterbahnen aus einem Verbundwerkstoff sind.

5. Passive Komponente nach einem der vorhergehenden Ansprüche, wobei die Form und Lage der Leiterbahnen auf dem Substrat so gewählt ist, dass bei der Betriebsspannung der elektrisch rotierenden Maschine keine Teilentladung über die Leiterbahnen der passiven Komponente stattfindet.

6. Passive Komponente nach einem der vorhergehenden Ansprüche, wobei der Verbundwerkstoff ein Epoxidharz, das mit elektrisch leitfähigem Füllstoff mindestens bis zur Perkolationsschwelle gefüllt ist, umfasst.

7. Passive Komponente nach Anspruch 6, wobei der Verbundwerkstoff einen Farbstoff umfasst, der unter Zufuhr von elektrischer Energie die Farbe wechselt.

8. Passive Komponente nach einem der Ansprüche 6 oder 7, wobei der Verbundwerkstoff einen Farbstoff umfasst, der unter Zufuhr von elektrischer, respektive thermischer, Energie zersetzbar ist.

9. Passive Komponente nach einem der Ansprüche 6 bis 8, wobei der Farbstoff ausgewählt ist aus der Gruppe der aromatischen Heterocyclen.

10. Passive Komponente nach einem der Ansprüche 6 bis 9, wobei der Farbstoff ausgewählt ist aus der Gruppe folgender Strukturen 1 bis 6: 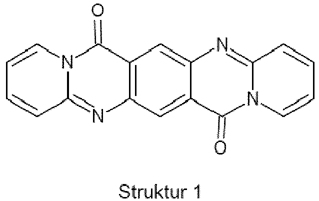 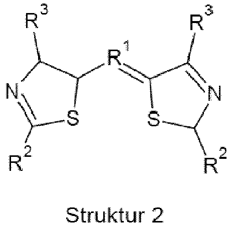 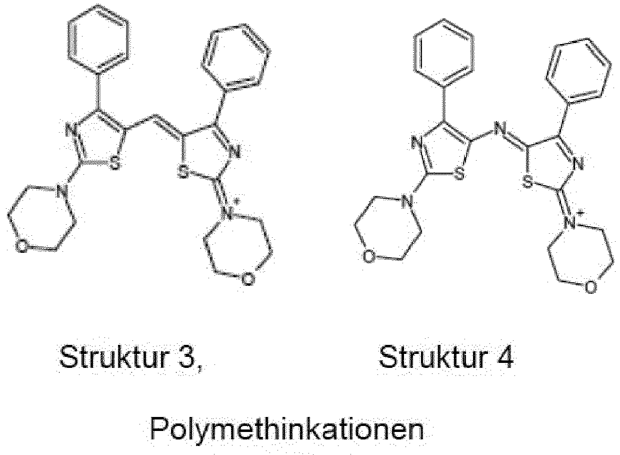 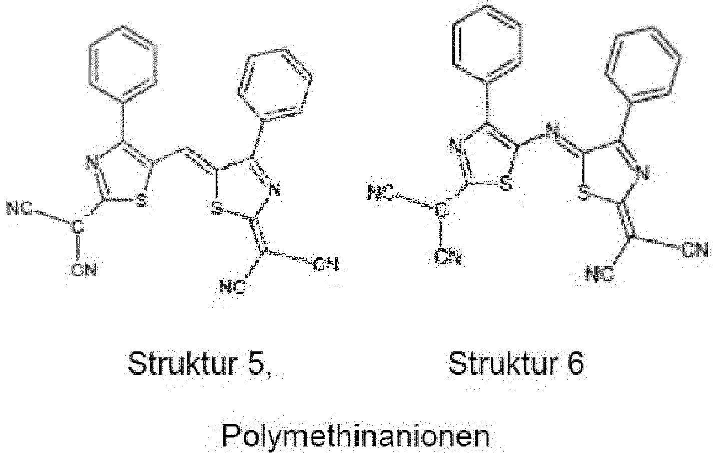 wobei
R¹ für - CH - , - konjugiertes Alkyl, -Aryl, -N-, -P-, -S-, - O-, sowie beliebige Kombinationen dieser Substituenten steht; R² und R³ jeweils gleich oder verschieden sein können und für beliebige Alkyl- und Aryl-Substituenten, mit oder ohne Halogenid-Substitution stehen und die Kationen oder Anionen zu den Polymethinionen einzeln oder in Kombination vorliegen und ausgewählt sind aus den folgenden ionogenen Gruppen:
- Einwertige anorganische oder organische Kationen, insbesondere Metallkationen
- Zweiwertige Kationen, insbesondere Erdalkalikationen
- Organische stickstoffhaltige Kationen
- Trimethylhydrogenammmonium
- Triethylhydrogenammonium
- Halogenid-Anionen, wie Cl⁻; Br⁻;
- Tetrafluoroboratanion BF₄⁻;
- Hexfluorophosphatanion PF₆⁻;
- Organische Anionen einfacher Wertigkeit.

11. Passive Komponente nach einem der vorhergehenden Ansprüche, wobei der elektrisch leitfähige Füllstoff im Verbundwerkstoff plättchenförmig und/oder globular vorliegt.

12. Passive Komponente nach einem der vorhergehenden Ansprüche wobei der elektrisch leitfähige Füllstoff im Verbundwerkstoff hell und/oder farblos ist.

13. Passive Komponente nach einem der vorhergehenden Ansprüche, wobei der Quadratwiderstand der jeweiligen Leiterbahn bei einer Schichtdicke im Bereich von 50 µm bis 500µm im Bereich von 10² bis 10⁷ liegt.

14. Passive Komponente nach einem der vorhergehenden Ansprüche, die zumindest eine Leiterbahn mit einer Schichtdicke im Bereich von 70pm bis 200µm mit einem Quadratwiderstand im Bereich von 10³ bis 10⁵ Ohm hat.

15. Passive Komponente nach einem der vorhergehenden Ansprüche, die durch Bedrucken, Besprühen, Dispensen und/oder Prägen des Substrats mit dem ungehärteten Verbundwerkstoff herstellbar ist.
